# EUROPEAN PATENT SPECIFICATION

(11) **EP 0 917 810 B1**
(45) Date of publication and mention of the grant of the patent: **27.08.2003**
(21) Application number: 98907101.4
(22) Date of filing: 19.03.1998
(51) Int. Cl.: H05B 33/02

(54) **ORGANIC ELECTROLUMINESCENT DEVICE**
ORGANISCHE ELEKTROLUMINESZENTE VORRICHTUNG
DISPOSITIF ELECTROLUMINESCENT ORGANIQUE

(30) Priority: 22.05.1997 EP 97201535
(43) Date of publication of application: 26.05.1999
(73) Proprietor: Koninklijke Philips Electronics N.V., 5621 BA Eindhoven (NL)
(72) Inventor: VLEGGAAR, Jeroen, Johannes, Marinus, NL-5656 AA Eindhoven (NL); LIEDENBAUM, Coen, Theodorus, Hubertus, Franciscus, NL-5656 AA Eindhoven (NL); HOEBERECHTS, Arthur, Marie, Eugène, NL-5656 AA Eindhoven (NL)
(74) Representative: van der Veer, Johannis Leendert
(86) International application number: IB9800402
(87) International publication number: WO98053644

(56) References cited:
- EP-A- 0 105 408
- WO-A-96/19792
- US-A- 4 618 802

## Description

The invention relates to an electroluminescent device comprising:
an electroluminescent element which includes an electroluminescent organic layer disposed between a hole-injecting electrode and an electron-injecting electrode; and
a housing which comprises
a first shaped part, a second shaped part and
an electrical leadthrough which contacts an electrode of said electroluminescent element;
said housing enclosing said electroluminescent element,
said electroluminescent element being mounted on said first shaped part,
said first and second shaped part being connected to each other by means of a closed ring of a sealing material, and
a clearance being present between said electroluminescent element and said second shaped part.

The invention further relates to a method of manufacturing such an electroluminescent device.

An electroluminescent (EL) device is a device which, while making use of the phenomenon of electroluminescence, emits light when the device is suitably connected to a power supply. If the light emission originates in an organic material, said device is referred to as an organic electroluminescent device. An organic EL device can be used, inter alia, as a thin light source having a large luminous surface area, such as a backlight for a liquid crystal display or a watch. An organic EL device can also be used as a display if the EL device comprises a number of EL elements, which may or may not be independently addressable.

The use of organic layers as an EL layer in an EL element is known. Known organic layers generally comprise a conjugated, luminescent compound. Said compound may be a low-molecular dye, such as a coumarin, or a high-molecular compound, such as a poly(phenylenevinylene). The EL element also comprises two electrodes, which are in contact with the organic layer. By applying a suitable voltage, the negative electrode, i.e. the cathode, will inject electrons and the positive electrode, i.e. the anode, will inject holes. If the EL element is in the form of a stack of layers, at least one of the electrodes should be transparent to the light to be emitted. A known transparent electrode material for the anode is, for example, indium tin oxide (ITO). Known cathode materials are, inter alia, Al, Yb, Mg:Ag, Li:Al or Ca. Known anode materials are, in addition to ITO, for example, gold and platinum. If necessary, the EL element may comprise additional organic layers, for example, of an oxadiazole or a tertiary amine, which serve to improve the charge transport or the charge injection.

An EL device of the type mentioned in the opening paragraph is disclosed in a publication by Burrows et. al., published in Appl. Phys. Lett. 65 (23), 1994, 2922. Said known device consists of an organic electroluminescent element which is built up of a stack of an ITO layer, an EL layer of 8-hydroxyquinoline aluminium (Alq₃), a hole-transporting layer of N,N-diphenyl-N,N-bis(3-methylphenyl)1,1-biphenyl-4,4'diamine and an Mg:Ag layer, which is provided with a silver layer. Said EL element is surrounded by a housing consisting of a bottom plate and a top plate which are made of glass, said plates being interconnected by an epoxy-based adhesive for sealing. Said ITO layer also forms the electrical leadthrough for the anode; the Mg:Ag/Ag layers also form the electrical leadthrough for the cathode. Said leadthroughs are electrically insulated from each other by a layer of silicon nitride. The known device has disadvantages which render it unsuitable for use in durable consumer goods, such as a display or a backlight for a liquid crystal display or a watch. Already after several hours, a deterioration of the uniformity of the luminous surface occurs which can be observed with the unaided eye. Said deterioration, which also takes place when the EL device is not in operation, manifests itself, for example, by so-called "dark spots" which are formed so as to be dispersed over the entire luminous surface. Also the presence of the housing itself gives rise to degradation of the EL device. For example, the epoxy-based adhesive gives off substances which are detrimental to the EL element. In addition, the manufacture of the EL device is time consuming. For example, the curing of a suitable epoxy-based adhesive takes 24 hours.

One of the objects of the invention is to overcome, or reduce, these disadvantages. The invention specifically aims at an EL device of which the uniformity of the luminous surface exhibits a deterioration in the course of time which can hardly, if at all, be observed with the unaided eye when said device is stored or operated under atmospheric conditions which may or may not be extreme. The invention particularly aims at precluding "dark spots" caused by the action of air and water. A further object is to provide an EL device which is compact and robust under normal production and operating conditions, and which exhibits a satisfactory resistance to mechanical and varying thermal loads. In addition, it should be possible to manufacture the housing of said EL device in a simple and cheap manner without the necessity of using, for example, expensive vacuum equipment. The housing should be such that neither its presence nor its manufacture give rise to degradation of the EL element. The performance of the EL element, for example measured in terms of luminance at a given voltage, should be comparable to corresponding elements which are stored or operated in an inert atmosphere.

These objects are achieved by an EL device of the type mentioned in the opening paragraph, which is characterized in accordance with the invention in that said sealing material is a low-melting metal alloy rendering the housing air tight and waterproof, and
said second shaped part is provided with said electrical leadthrough which is electrically insulated from said closed ring.

The use of a housing which is sealed by a low-melting metal or a low-melting metal alloy, which is provided from the melt or at a temperature near the melting point, enables an EL device to be obtained having a luminous surface whose uniformity exhibits no visible deterioration when the device is stored for at least 650 hours or operated for at least 400 hours under atmospheric conditions. In particular "dark spots" visible with the unaided eye are not observed, not even under extreme conditions. For example, exposure to alternating hot and cold baths of hot water and icewater for several days does not adversely affect the uniformity of the luminous surface of the EL device, which also proves that the EL device has a good resistance to mechanical and varying thermal loads. The thickness of the EL device typically is several millimetres and of the same order of magnitude as EL devices which are not provided with the housing in accordance with the invention. Said housing can be manufactured in a few minutes, and sealing of said housing takes only approximately ten seconds. The manufacture of the housing does not require expensive vacuum equipment. It has been found that the performance of the device is comparable to that of EL elements which are operated and stored in dry nitrogen. In a typical example, in which a poly(phenylenevinylene) was used in the EL layer, the luminance was 200 Cd/m² at 5.5 V and the EL efficiency was 1.2%.

Extensive experiments carried out by the inventors showed that the degree to which the housing should be air tight and waterproof must be such that organic materials cannot be employed as barrier materials in the housing. Even epoxy-based adhesives and high-molecular, halogenated or non-halogenated hydrocarbons, which are reputed to be the best barrier materials within the class of organic materials, are unsuitable. For example, apart from the worse barrier properties, the large difference between the coefficients of expansion of these materials and, for example, glass, and the resulting bonding problems proved to be disadvantageous. In addition, a conclusion which can be drawn from this is that the organic EL layer of the EL element must be screened completely by the housing.

In accordance with the invention, the choice of the metal used to seal the housing is limited, by the melting point. It is essential that the metal or metal alloy used for sealing has a low melting point to preclude damage to the EL element when said metal or metal alloy is processed from the melt. In this connection, a metal or metal alloy is considered to have a low melting point if processing from the melt does not lead to thermal degradation of the organic EL layer. The permissible melting point can be higher as the spacing between the metal and the organic EL layer of the element is greater, or as the time during which the element is exposed to the elevated temperature is shorter. If the intended application of the EL device does not require a compact housing, use can even be made of a low-melting glass having a melting point, for example, of 400 °C. However, the melting point must not be so low that the metal melts under normal operating conditions of the EL device.

From the above, it can be concluded that a suitable metal or metal alloy preferably has a melting point in the range between 80 °C and 250 °C. The metal is more widely applicable if the melting point ranges between 90 °C and 175 °C, or better still, between 100 °C and 150 °C, the optimum melting point being approximately 110 °C.

The housing comprises a first and second shaped part, said first and second shaped part being connected to each other by means of a closed ring of a sealing material, and
a clearance being present between said electroluminescent element and said second shaped part. Unlike a construction where the entire EL element is covered with a sealing material, the use of a closed ring which interconnects shaped parts minimizes direct contact between the housing and the EL element, and consequently the risk that the housing physically or chemically damages the EL element during manufacture or use.

It has nevertheless been found that the presence of the housing may adversely affect the performance of an EL element. For example, it may happen that the brightness of the light-emitting surface of a particular EL device is far from uniform across the light-emitting surface of the EL device, which appears to be a special problem if the EL layer is spin-coated. Also, it may happen that the voltage required to obtain a specified brightness is higher for an EL element enclosed in a housing than for an EL element which is not enclosed in a housing, yet is otherwise identical, the latter element being operated in an inert atmosphere.

It is also an object of the invention to eliminate or at least reduce these adverse effects. It is therefore an essential aspect of the invention that the EL device in accordance with the invention comprises a housing of which said second part is provided with said electrical leadthrough.

The inventors have found that the undesirable effects are due to the fact that the electrical leadthrough is located on the same shaped part as the EL element, viz. the first shaped part. Specifically, it has been found that its presence may lead to such a topography that it is difficult or impossible to obtain an organic EL layer of uniform thickness by spin-coating. A uniform thickness is a prerequisite to obtain an EL device of uniform brightness. Also, if ITO is used as the anode, and high temperatures are involved in the manufacture of the electrical leadthrough, the conductivity and/or the hole-injection efficiency of the ITO is found to decrease. As a result, the brightness of the EL element at a specified voltage will be less and the uniformity of a large luminous surface will be worse. By providing the second shaped part with the electrical leadthrough, instead of the first, the manufacture thereof can take place separately from the manufacture of the EL element, for it is at the end of the manufacture of the EL device that the first and second shaped part are connected to each other by means of the closed ring of the low-melting metal alloy. In this manner, the ITO need not be subjected to high temperatures.

Also, the number of process steps to which, respectively, the first respectively the second shaped part are subjected in order to manufacture the EL device, is better balanced, which, all other factors being equal, leads to a process with a higher yield. In this respect, it is noted that, if the yield is to be optimized, and assuming that the yield of individual process steps is equal, the total number of steps should be evenly distributed between the first and the second shaped part.

A particular, preferred embodiment is characterized in accordance with the invention in that the metal alloy comprises an element selected from the group formed by In, Sn, Bi, Pb, Hg, Ga and Cd. Many types of low-melting metal alloys are commercially available at a low price. The majority of the commercially available alloys comprise an element of the above group. Apart from a broad spectrum of melting points, said metals also offer a broad spectrum of other properties which are important for the housing, such as sensitivity to oxidation, adhesion to materials to be combined, such as glasses and indium tin oxides, coefficient of thermal expansion, ductility, dimensional stability, degree of shrinkage upon solidification and wetting. In applications in which toxicity is an important factor, alloys containing Hg or Cd, such as Sn (50 wt.%) Pb (32 wt.%) Cd (18 wt.%) are not to be preferred. If a somewhat flexible EL device is necessary, it is advantageous to use a ductile low-melting metal, such as indium (melting point 157 °C) or Sn(35.7 wt.%)Bi(35.7 wt.%)Pb(28.6 wt.%), which has a melting point of 100 °C. To minimize stresses caused by solidification, a metal which, upon solidification, does not form crystalline domains and exhibits little shrinkage, such as Bi(58 wt.%)Sn(42 wt. %), melting point 138 °C, is to be preferred.

Particularly suitable low-melting metal alloys include:
Bi(54.1)In(29.6)Sn(16.3) melting point 81 °C,
Bi(44.0)Sn(14.5)Cd(7.0)Pb(34.4) melting point 91 °C,
Bi(51.6)Pb(40.2)Cd(9.2) melting point 92 °C,
Bi(40.0)Sn(20.0)Pb(40.0) melting point 95-120 °C,
In(52)Sn(48) melting point 118 °C,
Bi(56.5)Pb(43.5) melting point 125 °C,
Bi(58)Sn(42) melting point 138 °C,
Sn(51.2)Pb(30.6)Cd(18.2) melting point 145 °C,
In(97)Ag(3) melting point 146 °C,
Pb(37)Sn(63) melting point 183 °C,
where the numbers in brackets are weight percentages. Of these alloys, those having melting points below 125 °C are particularly preferred if low melting points and a small degree of shrinkage upon solidification is desired. Of the latter alloys, the ductile alloy In(52 wt%)Sn(48 wt%) is particularly preferred.

Sealing of the housing by means of a low-melting metal or a low-melting alloy proves to be surprisingly simple. Methods which are known per se and which are suitable for mass-production and for large surfaces prove to be suitable. Suitable methods are, inter alia, thermocompression, soldering, spray coating, or if local heating is desirable, melting by means of, for example, a laser. Particularly suitable methods are foil-melting, dip-coating or drop-casting. These methods have in common that the metal is processed from the melt. As a result, these techniques do not require expensive vacuum equipment and, in addition, enable relatively thick layers, typically, of hundred micrometers to be formed in a short period of time, typically, approximately ten seconds. To obtain an air tight and waterproof seal, it is important that the metal can be provided from the melt in a sufficiently large thickness. A suitable layer has a thickness in excess of one micrometer, for example approximately ten micrometers, or better still, several hundred micrometers. As regards other properties, such as flexibility, it is advantageous to use a smaller layer thickness of 1 to 10 micrometers.

A particular embodiment in accordance with the invention is characterized in that the low-melting metal or the low-melting alloy is provided with a bonding layer. The resistance to mechanical and varying thermal loads can be improved further if the device is provided with a bonding layer before the metal is applied. A further advantage of the use of a bonding layer is that the metal can be provided in accordance with a pattern, while using differences in wettability. In this manner, a patterned, low-melting metal layer can be formed by means of dip-coating. In addition, the bonding layer serves as a barrier to any diffusion of atoms from the low-melting metal towards the EL element.

The bonding layer greatly improves the solderability of the surface on which it is provided. In the context of the invention, the bonding layer is also referred to as a solderable layer. Also, the terms low-melting metal alloy and solder are used interchangeably.

The bonding layer can be provided, for example, by electroless deposition of silver and/or a nickel phosphor. A particularly suitable bonding layer is obtained by screen-printing of a solderable, silver-containing glass paste. In this manner, the bonding layer, having a thickness of typically several tens of micrometers, can be provided in accordance with a pattern and in a short period of time without the use of vacuum equipment. If necessary, suitable bonding layers, containing, for example, Ag, Ni, Cr, Cu or Pt, can alternatively be provided by vapor-deposition or sputtering, whether or not by simultaneously or successively using different sources. A stack of bonding layers can also be obtained in said manner. Particularly Cr/Ni, Cr/Ni/Ag, Pt/Ag and Pt/Cu stacks can suitably be used as a bonding layer between the EL element and the low-melting metal. Vapor-deposited or sputtered layers on the basis of Ni, Ni/Cu, Ni/Ag, Cr/Ni, Cr/Ni/Ag and Pt/Ag can suitably be used as the bonding layer between glass and the low-melting metal. V or Ti can be used instead of Cr. Bonding layers thus provided typically have a layer thickness of 100 to 500 nm.

A particular embodiment in accordance with the invention is characterized in that the organic layer comprises an electroluminescent polymer. Electroluminescent polymers are suitable EL materials. They have good luminescent properties, a good conductivity and good film-forming properties. If use is made of simple techniques, such as spin-coating, EL layers having a large surface area can be manufactured by means of these materials. Suitable polymers generally have a conjugated "backbone", such as soluble polyphenylenephenylenevinylenes, soluble poly-thiophenes and soluble poly-phenylenes. Polyphenylenevinylenes are very suitable EL materials. By means of substitution, in particular, in the 2- and 5-positions of the phenyl ring, the emission spectrum can be varied and readily soluble and processable variants can be obtained. In addition, said polymers are generally readily processable and yield amorphous layers. Polymers which are particularly suitable are 2,5 alkyl- or alkoxy-substituted poly-phenylenevinylenes.
Examples of particularly suitable poly-phenylenevinylenes are:
poly(2-methyl-5-(n-dodecyl)-p-phenylenevinylene)
poly(2-methyl-5-(3,7-dimethyloctyl)-p-phenylenevinylene)
poly(2-methyl-5-(4,6,6-trimethylheptyl)-p-phenylenevinylene) poly(2-methoxy-5-decyloxy-p-phenylenevinylene)
poly(2-methoxy-5-(2-ethylhexyloxy)-p-phenylenevinylene) (MEH-PPV).

The combination of the housing in accordance with the invention and an EL element whose organic EL layer comprises a 2,5-substituted poly(phenylenevinylene) is particularly advantageous, as experiments carried out by the inventors have shown that, in the absence ot a protective housing according to the invention, many poly(phenylenevinylene) variants already show degradation if they are exposed to temperatures of 80 to 100 °C for a long period of time.

A further preferred embodiment of the invention is characterized in that the housing comprises an electrical leadthrough which is at least partly enclosed in a low-melting glass. To apply a voltage across the electrodes of the EL element, the housing must be provided with at least two electrical leadthroughs. To preclude a short-circuit, said leadthroughs must be electrically insulated from other parts of the housing and, in particular, from each other. For this purpose, use can be made of air tight and waterproof insulators such as silicon nitride and silicon oxide, which are known per se.

Preferably, however, a low-melting glass is used as the insulator. The expression "low-melting glass" is to be understood to mean herein a glass having a melting point which is so low that, if said glass is processed from the melt, it does not adversely affect the operation of the EL device. This means that, given the thermal resistance of the organic EL layer, the low-melting glass can only be provided when the organic EL layer does not yet form part of the EL device in the process of being formed. Initial experiments have revealed that at least in case of EL elements having a small luminous surface, low-melting glasses provided on an ITO layer do not adversely affect the properties of said ITO layer.

Many variants of low-melting glasses having minimum melting points of approximately 350 °C are commercially available. Suitable glasses are, for example, lead-borate glasses filled with ceramic materials. The low-melting glass layer can be provided, whether or not in accordance with a pattern, by means of methods which are known per se, such as screen-printing. In these methods, glass powder is formulated so as to form a paste which is provided on the substrate, whereafter said paste is sintered in a furnace, thereby forming the electrically insulated, air tight and waterproof glass.

Various variants of the housing are possible. In a first variant, the EL element is surrounded by two shaped parts, for example two glass plates, which are interconnected by means of a closed ring of a low-melting metal or metal alloy. The specific shape of the parts determines how many of such rings are necessary to seal the housing. For example, to seal a disc-shaped dial plate of a watch, which is provided with a duct for interconnecting the dials and the drive mechanism, two concentric closed rings are necessary.

Said shaped parts can be manufactured from air tight and waterproof materials which are known per se. Suitable materials are, for example, high-melting metals, metal alloys or glass. As regards the light emission, it is advantageous to manufacture at least one of the shaped parts from a material which is transparent to the light to be emitted. Moreover, to save space, it is advantageous to use this shaped part as the substrate for the EL element.

Electrical leadthroughs can be realized in many ways. For example, an electrically conducting, transparent shaped part, such as a glass plate provided with a layer of ITO, can be used as an electrical leadthrough, while an electrically insulating, transparent shaped part is suitable to realize patterned or independently addressable leadthroughs and electrodes. A housing which is simple in terms of construction can be obtained by using the low-melting metal or metal alloy as the electrical leadthrough. An electrical leadthrough can also readily be provided in an insulating shaped part.

According to the invention, the second shaped part is provided with the electrical leadthrough. It may be in electric contact with the electron-injecting electrode, that is the cathode, or the hole-injecting electrode, that is the anode, of the EL element. The second shaped part can also be provided with two electrical leadthroughs, i.e. one for the anode and one for the cathode. If additional electrical leadthroughs are required, the second shaped part is preferably provided with all of them so as to fully exploit the advantages offered by the invention. If desired, the closed ring may serve as an electrical leadthrough.

A suitable embodiment of the EL device in accordance with the invention is characterized in that the electrical leadthrough is led through the second shaped part. In one example, which is particularly useful if electromagnetic shielding is required, the second shaped part is a metal plate in which a small hole has been made so as to accommodate an electrical leadthrough in the form of a wire or strip of metal, which is surrounded circumferentially by an insulator so as to electrically insulate the wire from the metal plate. In another example, the second shaped part is a glass plate through which a metal wire or strip is led.

The length and properties of the metal wire are chosen to be such that when the first and second shaped part are connected to each other, good electric contact between the electrode and the (end of the) wire will be established. If desired, the end of the wire may be provided with a drop of the low-melting metal alloy from which the closed ring is made.

Using an electrical leadthrough which is led through a shaped part has its disadvantages. If an EL device having many such leadthroughs is required, this construction is not very practical and the resolution which can be obtained is rather limited, i.e. typically of the order of millimeters. Making a lot of holes is cumbersome and may adversely affect the mechanical strength of the shaped part.

In order to at least reduce these disadvantages, a preferred embodiment of the EL device in accordance with the invention is characterized in that said electrical leadthrough is provided on said second shaped part. In order to insulate the electrical leadthrough from the closed ring, an insulator is provided on the electrical leadthrough. Preferably, in order to improve the adhesion between the closed ring and the insulator, the insulator is provided with a bonding layer. This bonding layer is preferably also used to selectively deposit the low-melting metal alloy according to a desired pattern such as a closed ring. Examples of insulators, bonding layers and low-melting metal alloys which can be suitably used to obtain an air tight and waterproof housing have already been described hereinabove, however it is noted that the temperature constraints imposed by the EL element do not apply in this case.

Preferably, the electrical leadthrough and the bonding layer are made of a low-melting glass which is rendered electrically conducting by the addition of metal particles. Preferably, silver particles are used since they render layers made of said glass solderable. The insulating layer is preferably made of an (insulating) low-melting glass. If these low-melting glasses are used, the layers can be applied in the form of a glass paste using thick-film printing techniques such as silk-screen printing, thus a simple, reliable manufacturing process can be used which is also very suitable for mass production. The resolution of silk-screen printing is about 75 micrometers. If a better resolution is required offset printing may be used and/or the electrical leadthrough can be patterned using photolithography.

A preferred embodiment of an EL device of which the second plate can be processed using only simple printing methods such as silk-screen printing and dip coating is characterized in that
the electrical leadthrough comprises a low-melting glass filled with silver particles,
the electrical leadthrough is electrically insulated from the closed ring of low-melting metal alloy by a patterned layer of a low-melting glass, and
the closed ring of low-melting metal alloy is supported by a patterned bonding layer of a low-melting glass filled with silver particles.

In order to provide adequate electrical insulation, the layer of a low-melting glass need only be present where the closed ring of a low-melting metal alloy and the electrical leadthrough overlap each other. However, it has been found advantageous to provide the patterned layer of the low-melting glass in the form of a closed ring which completely underlies the closed ring included in the patterned bonding layer.

The second shaped part provided with the leadthrough creates an additional problem in that, for the operation of the EL device, it is essential that the electrical leadthrough contacts the desired electrode of the EL element. It is surprisingly found that the alignment, which is needed to obtain a correct registration of the electrode and the leadthrough, is accomplished when the first and the second shaped part are joined together by means of a closed ring of molten low-melting metal alloy.

The invention therefore also relates to a method of manufacturing an electroluminescent device which method comprises the steps of:
mounting, on a first plate,
an electroluminescent element, which comprises
an electroluminescent organic layer disposed between a hole-injecting electrode and an electron-injecting electrode,
selectively providing said first plate with a bonding layer according to a desired pattern, said pattern including a first closed ring,
selectively providing a second plate with a layer of a low-melting metal alloy according to a desired pattern, said pattern including a second closed ring, and with an electrical leadthrough which is electrically insulated from said second closed ring,
said second closed ring being mated to said first closed ring,
melting the low-melting metal alloy by heating said second closed ring to a temperature above the melting point of the low-melting metal alloy,
joining said first and said second plate to each other by mating the first and the second closed ring,
while forming an air tight and waterproof housing which encloses said electroluminescent element,
while bringing said electrical leadthrough and an electrode of said electroluminescent element, into contact with each other,
while forming a clearance between said electroluminescent element and said second plate, and
solidifying said molten low-melting metal alloy.

The self-aligning property of the method is a result of the fact that the molten metal alloy seeks to minimize its surface tension. Using this method of aligning the first shaped part with respect to the second shaped part so as to establish a correct registration of the leadthrough and the electrode, a resolution of 150 micrometers or larger, such as 350 micrometers, can be easily achieved. By using interlaced or interdigitated electrodes, the resolution of a display device which is manufactured using this method can be increased by a factor of two.

If the leadthrough is provided on the second shaped part, the end portion of the leadthrough which ends up being located on the inside of the housing, is preferably provided with a bonding layer as described above, on top of which a low-melting metal alloy is provided. This construction can also be used in display applications where many electrical leadthroughs are required.

A preferred method of manufacturing an electroluminescent device is characterized in that use is made of a common first and a common second plate by means of which a plurality of integrated electroluminescent devices are simultaneously made and which method, after solidification of the molten low-melting metal alloy, comprises the step of separating the plurality of integrated electroluminescent devices into a plurality of discrete electroluminescent devices. Using a manufacturing method which yields a plurality of EL devices on substrate common simplifies the manufacturing process and increases throughput. The risk of damaging the EL devices is minimized if the EL devices are separated after the common substrates are joined together. Said separation can be conveniently achieved by conventional methods, by spin-coating and sawing. If the EL layer is to be processed from solution, using for example spin-coating, it is imperative that the substrate onto which the EL layer is applied is substantially planar. The fact that, in accordance with the invention, any topography caused by the presence of the leadthroughs is accommodated by the second shaped part is of particular advantage if a common substrate is used.

The air tight and waterproof housing which is part of the electroluminescent device according to the invention can also be used to enclose large area elements other than electroluminescent elements which, on the one hand, must be protected from the influence of water and oxygen by a hermetic seal and on the other hand need electrical leadthroughs so as to enable the elements to be connected to a voltage source located outside the housing. An even simpler housing is obtained by leaving out the leadthroughs. Such a housing may be useful as a hermetically sealed storage and/or transport container.

These and other aspects of the invention will be apparent from and elucidated with reference to the embodiments described hereinafter.

In the drawings:
Figure 1 is a schematic, cross-sectional view of a first embodiment of the EL device in accordance with the invention,
Figure 2 is a schematic, cross-sectional view of a second embodiment of the EL device in accordance with the invention,
Figure 3 is a schematic, plan view of a third embodiment of an EL device in accordance with the invention,
Figure 4 is a schematic, cross-sectional view of the third embodiment of an EL device in accordance with the invention, taken on the line I-I in Figure 3, and
Figures 5A, 5B and 5C schematically show successive stages of the third embodiment of an inventive EL device under construction.

### Exemplary embodiment 1

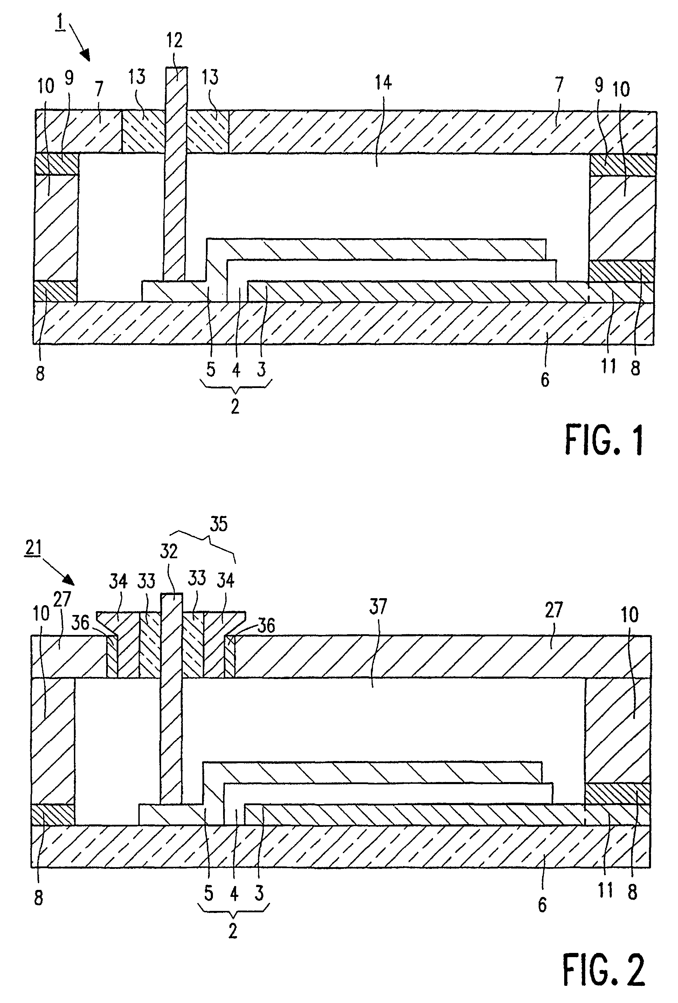

Figure 1 is a schematic, cross-sectional view of a first embodiment of an EL device 1 in accordance with the invention. For the sake of clarity, this and subsequent drawings are not drawn to scale and some parts have been drawn on an enlarged scale relative to others. The EL device 1 comprises an EL element 2. The EL element 2 comprises an electroluminescent organic layer 4 disposed between a hole-injecting electrode 3 which is transparent to the light to be emitted, and an electron-injecting electrode 5. The EL element 2 is enclosed by an air tight and waterproof housing, which is formed by the parts 6 through 13. The housing comprises a first shaped part in the form of a glass plate 6 which is transparent to the light to be emitted. The EL element 2 is mounted on the plate 6, which thus serves as a substrate for the EL element 2. The housing further comprises a second shaped part in the form of a glass plate 7. The plates 6 and 7 are connected to each other by means of a closed ring of a low-melting metal alloy 10 so as to hermetically seal the air tight and waterproof housing. The closed ring of solder 10 is joined to the plate 6 via an electrically conducting, bonding layer 8 in the form of a closed ring of which the shape is identical to the that of closed ring 10. Similarly, the closed ring of solder 10 is joined to the plate 7 via a bonding layer 9 in the form of a closed ring of which the shape is identical to that of the closed ring 10. The bonding layer 8 covers a section 11 of the layer comprising the hole-injecting electrode 3, thereby providing electric contact between the electrode 3 and the closed ring 10. The closed ring 10 therefore also serves as an electrical leadthrough. An electrical leadthrough 12 in the form of a metal strip is led through the plate 7 and makes contact with the electron-injecting electrode 5. The leadthrough 12 is secured in an air tight and waterproof manner in the plate 7 by means of the electrically insulating, air tight and waterproof fritted glass 13. The electrical leadthrough 12 is electrically insulated from the closed ring 10. A gas-filled clearance 14 is present between the EL element 2 and the plate 7.

By way of example, the EL device 1 is manufactured as follows:

### 1. Processing of the first shaped part

A glass plate 6 of dimensions 64 x 64 X 1 mm which has been provided with a 150 nm thick layer of indium tin oxide so as to form a hole-injecting electrode 3 and the section 11 (supplier Balzers) is cleaned by means of, respectively, soap, water and isopropanol. An approximately 150 nm thick organic EL layer 4 is provided by spin-coating from a 0.6 wt. % solution of poly[2-methoxy-5-(2,7-dimethyloctyloxy)-1,4-phenylenevinylene], synthesized in toluene in accordance with the method described in Braun et. al., Synth. Met., 66 (1994), 75. The EL material is removed along the edges by means of a cotton bud and/or a razor blade. In mass-production, laser ablation is a particularly preferred method of removing the superfluous EL material. Yb is vacuum-deposited, via a mask, thereby forming a 200 nm thick electron-injecting electrode 5. The EL element 2 is now complete and is mounted on the first glass plate 6. Using a mask, an approximately 200 nm thick layer of nickel and a 200 nm thick layer of silver are successively provided by means of magnetron-sputtering and vapor-deposition, respectively, thereby forming the patterned bonding layer 8 in the shape of a first closed ring. The bonding layer 8, being only a few hundred nanometers thick, may also be provided prior to the EL layer without adversely affecting the spin-coating process.

### 2. Processing of the second shaped part

In a process carried out at another time and/or place than the processing of the first plate, a second plate 7 of plain window glass having dimensions similar to glass plate 6 is sandblasted using a mask so as to from an aperture having a width of a few millimeters. A flexible strip 12 of FeNiCo, other metals such as nickel and copper being been equally suitable which strip is protected from oxidation by a thin platinum coating, is fed through the aperture. A paste of low melting glass (type LS0206 available from Nippon Electric glass Co. Ltd.) is applied around the strip so as to fill the gap between the plate and the strip. The glass paste is dried at 120 °C in air for 15 min, the temperature then being slowly increased to 450 °C at which temperature a sintering process is carried out for 10 min, thereby forming the air tight and waterproof fritted glass 13. Using the same method and materials as for the application of the bonding layer 8, the second plate is provided with a patterned bonding layer 9 in the form of a closed ring which is mated to the first closed ring present on plate 6. The resulting plate is dipped into a bath containing the low-melting metal alloy Sn(50 wt.%)Pb(32 wt.%)Cd(18 wt.%) (supplier Witmetaal b.v.), melting point 145 °C, kept in liquid form at 155 °C. Upon removal of the plate from the bath only the bonding layer 9 is provided with the solder, thereby forming a second closed ring which is mated to the first closed ring present on plate 6. The second closed ring is electrically insulated from the strip 12. If the strip 12 is solderable, solder is deposited thereon as well.

### 3. Connecting the first and the second shaped part

The processed plates 6 and 7 are placed on a hot stage kept at 155 °C, which causes the low-melting metal alloy to melt. The plates 6 and 7 are then joined by mating the first and second closed ring. It is sufficient to put the first plate on top of the second plate such that the first closed ring is approximately positioned over the second closed ring. The self-aligning property of the molten low-melting metal alloy then pulls the two closed rings into their final position of maximum overlap while at the same time the metal strip 12 and the electrode 5 are brought into contact with each other. When cooling down, the closed ring 10 solidifies so as to form an air tight and waterproof housing which encloses the EL element 2. Since the closed ring 10 is 200 micrometers thick, a clearance 14 is present between the EL element 2 and the plate 7, which, since the joining of the plates 6 and 7 is performed in a dry nitrogen atmosphere, is filled with dry nitrogen gas.

If the now completed EL device 1 is connected to a DC power source, and a voltage of 6 V is applied to the electrodes 3 and 5 by means of, respectively, the leadthroughs 10 and 12, the electrode 5 being used as the negative electrode, a luminous surface appears which emits orange light. To the unaided eye, the luminous surface appears very uniform. At 6 V the luminance is about 1000 Cd/m².

EL devices manufactured according to the method described above, are submitted to a number of durability tests.

In a first test, i.e. a climate test, an EL device thus obtained is immersed, under otherwise ambient conditions, in a water bath of 80 °C for approximately 10 seconds and, immediately afterwards, in a melting ice bath for approximately 10 seconds. This procedure is repeated for 48 hours. After drying, a voltage of 6 V is applied to the electrodes 3 and 5 as a result of which a luminous surface emitting orange light emerges. The luminous surface does not exhibit "dark spots". To the unaided eye, the uniformity of the luminous surface is equal to that of a control EL device without a housing, which is manufactured, and directly measured, in a dry nitrogen atmosphere.

In a second test, a shelf life test, an EL device is stored under ambient conditions and the luminance and the current are measured at regular intervals at a voltage of 6 V. During at least 650 hours, the current remains substantially constant and amounts to 0.028 A, whereas the luminance decreases slightly from 130 to 115 Cd/m². Also in this case, the uniformity of the luminous surface is unchanged. The decrease in luminance takes place uniformly over the entire surface area. Also after 650 hours, the surface is still free of "dark spots".

### Exemplary embodiment 2

Figure 2 is a schematic, cross-sectional view of a second embodiment of an EL device 21 in accordance with the invention. The EL device 21 is similar to that of the first embodiment - identical items being identified with identical reference numbers - but differs in that the plate 7 is replaced by a metal plate 27, for example, of nickel or copper. The metal plate is provided with an air tight and waterproof insulated electrical leadthrough 35 which consists of a metal wire 32 circumferentially surrounded by an electrical insulator 33 which is secured in a metal ring 34. The electrical leadthrough 35 is commercially available. It is for example used as an electrical leadthrough for a diode laser.

The processing of the first shaped part and the joining together of the first and the second shaped part is done using a method similar to that described in exemplary embodiment 1. By way of example, the second plate may be processed as follows:

A copper plate 27 is cleaned successively with soap, water and isopropanol. Using the low-melting metal alloy In(52 wt%)Sn(48 wt%), having a melting point of 118 °C and comprising a suitable quantity of a solder flux, a closed ring 10 of a low-melting metal alloy is provided along the edges of the plate 27. In order to remove the organic matter present in the solder flux, the surface of the closed ring is cleaned using water and isopropanol. A 1 cm wide hole is then drilled into the plate 27 into which a diode laser foot (available from Shinko, Japan) is placed. Using ordinary Pb(37 wt%)Sn(63 wt%) solder, which melts at 183 °C, i.e. a temperature considerably higher then the melting point of the metal of the closed ring 10, the diode laser foot is secured in an air tight and waterproof manner in the plate 27.

If the EL device 21 is subjected to the durability tests of exemplary embodiment 1, similar results are obtained.

### Exemplary embodiment 3

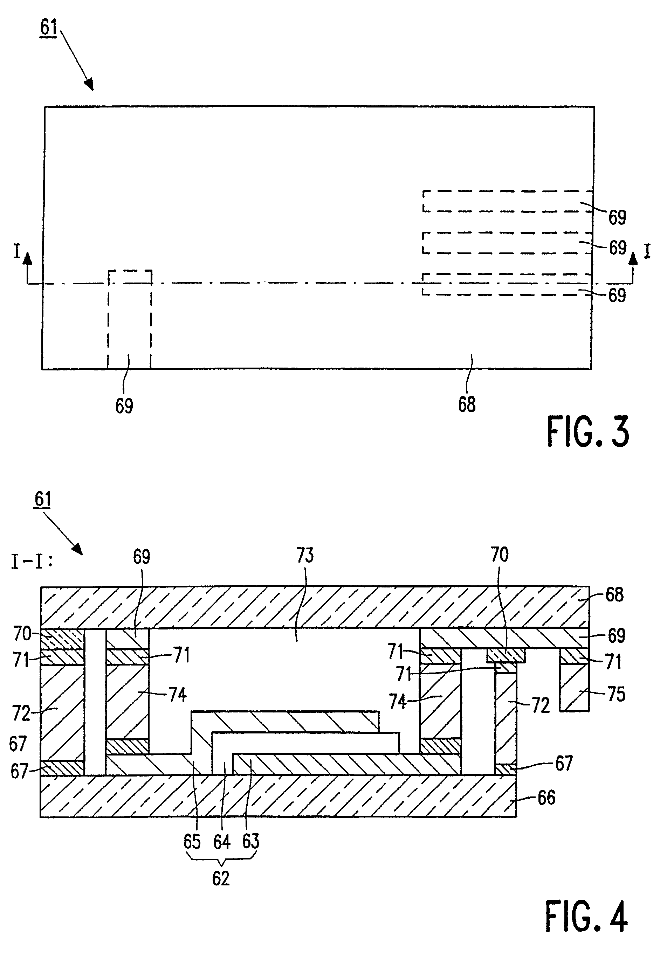

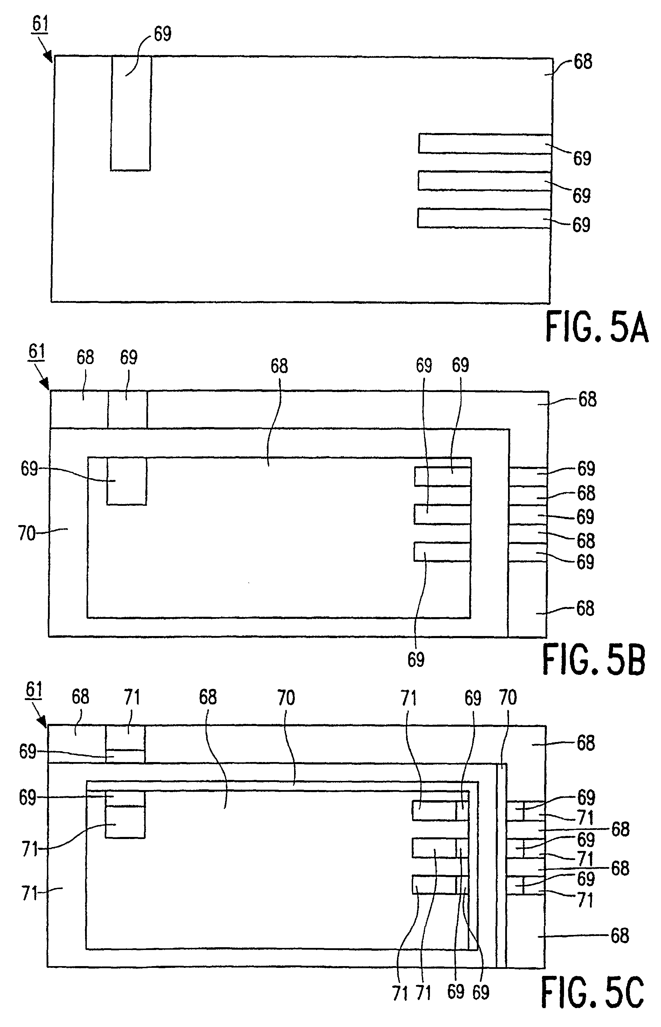

Figure 3 is a schematic, plan view of a third embodiment of an EL device in accordance with the invention. An EL device 61 in the form of a segmented display is shown. Dashed lines are used to indicate the position of some electrical leadthroughs 69 which are located on the side opposite to the viewing side of Figure 3. Figure 4 is a schematic, cross-sectional view taken on the line I-I in Figure 3. Figures 5A, 5B and 5C schematically show successive stages of the third embodiment of an inventive EL device under construction. The EL device 61 comprises a first plate 66 of electrically insulating glass which is transparent to the light to be emitted and on which there is mounted an indepedently adressable EL display element 62 having an EL layer 64 disposed between an electron-injecting electrode layer 65 and a patterned hole-injecting electrode layer 63 having a plurality of indepedently adressable hole-injecting electrodes. The EL device 61 further comprises a second plate 68 which is connected to the first plate 66 by means of the closed ring of low-melting metal alloy 72 so as to form an air tight and waterproof housing which encloses the EL element 62 in such a way that a clearance 73 is present between the EL element 62 and the second plate 68. In order to allow a power source located outside the housing to be connected to the electrodes of the EL element 62, electrical leadthroughs 69 are provided on the second plate 68. Of the row of leadthroughs 69 present on the plate 68 only a few are actually shown in Figure 3. The leadthroughs 69 are electrically insulated from the closed ring 72 by means of the electrically insulating patterned layer 70. As shown in Figure 5B, the layer 70 has the shape of a closed ring which, as shown in Figure 5C, entirely underlies the closed ring of the patterned bonding layer indicated by items 71. Electrical contact between the leadthroughs 69 and the electrodes 63 and 65 is established using the members 74 which are made of the same alloy as the closed ring 72. In order to allow for a convenient connection between the leadthroughs 69 and a power supply, the leadthroughs are provided with members 75 which are made of the same alloy as the closed ring 72. In order to render the first and the second plate solderable in accordance with a pattern, as well as to improve the adhesion between the plates and the low-meling metal alloy, patterned bonding layers 67 and 71 are provided.

The organic EL segmented display device 61 may be manufactured as follows:

### 1. Processing of the first shaped part

The first shaped part is processed by means of a method similar to that described in exemplary embodiment 1, with this difference that the ITO-covered glass plate 66 is of the dimensions 54 x 54 X 1 mm and is patterned in a conventional manner so as to form a patterned hole-injecting electrode layer 63 having 1 mm wide lines separated by 1 mm wide spaces.
Also, the bonding layer 67 is selectively provided on the plate 66 by succesively vacuum-depositing a 150 nm thick Cr(50 wt%)Ni(50 wt%) layer and a 50 nm thick Au layer, according to a desired pattern which is the same as the pattern indicated in Figure 5C by the items 71, with this difference that the sections corresponding to the sections 71 used to obtain the members 75 are absent. Alternatively, the bonding layer 67, being only a few hundred nanometers thick, may also be provided prior to the EL layer, without adversely affecting the spin-coating process.

### 2. Processing of the second shaped part

In a process carried out at another time and/or place than the processing of the first plate, a second plate 68 of plain window glass having dimensions of 64 x 64 x 1 mm is first of all provided with a patterned layer of electrical leadthroughs 69, each measuring 1 mm by 20 mm by 20 µm (microns) and having an electrical resistance of less than 0.1 Ohm, measured between the ends of a strip. To this end, a layer of a low-melting glass paste filled with silver particles is silk-screen printed onto the plate 68, according to the pattern shown in Figure 5A, and then dried for 10 min at 120 °C. The low-melting glass paste filled with silver particles is prepared by mixing 1 part by weight of a low-melting lead-borate glass (type LS-3124, supplier Nippon Electric Glass Co. Ltd.) and 1 part by weight of a paste code named XH96054JS, which contains 201 g silver particles and a binder, said binder containing equal parts by weight of alpha-terpineol and ethylcellulose. Adding low-melting glass ensures that upon sintering an air tight and waterproof leadthrough is obtained. Subsequently, a 20 µm (microns) thick electrically insulating low-melting glass layer 70 is screenprinted according to the pattern shown in Figure 5B using a lead-borate glass paste (type LS-3124, supplier Nippon Electric Glass Co. Ltd.) which is dried in air for 10 min at 120 °C. The width of the closed ring of the pattern indicated by the reference number 70 is 4 to 6 mm. Both layers are then sintered in an oven at 540 °C for 20 min. The patterned bonding layer 71 is then provided by screen printing a 20 micron thick layer of the low-melting glass paste filled with silver particles with the code name XH9700JS according to the pattern shown in Figure 5C, which is then sintered in an oven at 470 °C for 5 min. The paste XH9700JS is prepared by mixing, using a tree-way roller, 75 parts by weight of a mixture consisting of 8 wt. % lead-borate glass powder and 92 wt. % silver powder with 25 parts by weight of a binder, said binder containing equal parts alpha-terpineol and 50 wt. % ethylcellulose. After cooling down to room temperature, the oxide layer present on the surface of the bonding layer 71 is removed by rubbing the surface thoroughly with tungsten wool. The processed plate 68 is then dipped into a bath containing the low-melting metal alloy In(52 wt%)Sn(48 wt%), having a melting point of 118 °C and being kept in liquid form at 135 °C. Upon removal of the plate from the bath the solder only sticks to the silver-plated sections 71 of the plate 68.

### 3. Interconnecting the first and the second shaped part

The plates 66 and 68 obtained above are joined using the method described in exemplary embodiment 1. The members 74, which are made of the same solder material as the closed ring 72, and thus are also in the molten state at the time of joining as well, enable a reliable electrical contact to be made. The self-aligning property of the molten solder which is operative when the closed rings 72 and 67 are aligned is of particular importance in this embodiment since it ensures that each electric leadthrough 69 makes electrical contact with the correct electrode of the EL element. Since the closed ring 72 alone is already 200 micrometers thick, a clearance 73 is present between the EL element 62 and the plate 68, which, since the joining of the plates 66 and 68 is performed in a dry nitrogen atmosphere, is filled with dry nitrogen gas.

If a voltage of 6 V is applied to the electrodes a line pattern emitting orange light emerges instantly. By suitably applying a voltage to a subset of the hole-injecting electrodes and the common cathode any combination of lines can be made to light up.

If an EL device 61 thus manufactured is subjected to the durability tests described in exemplary embodiment 1, results similar to those obtained with EL device 1, are obtained.

For comparison, a control device not according to the invention is manufactured, which differs from the EL device 61 in that the electrical leadthroughs 69 are provided on the same plate as the EL element, that is, the first plate. When a voltage of 6 V is applied to all the electrodes, a line pattern emitting orange light emerges instantly. However, along the lines, the uniformity of the light is significantly less than that attained by the EL device 61. Also, the brightness of the brightest parts of the line pattern is significantly lower than the brightness of the light emitted by the EL device 61 operated at 6 V. If the electrical resistance of the ITO lines is measured, it is found that the conductivity of the ITO present on the EL device 61 is significantly higher than the conductivity of the ITO present in the control device.

### Exemplary embodiment 4, not according to the invention

As a comparative example, EL devices not in accordance with the invention are manufactured, which differ from the EL device 1 in that the bonding layers 8 and 9 are left out and the closed ring 10 is made of a cured epoxy adhesive. Dependent upon the type of epoxy and the manner in which it is cured, the service life of the EL device is only several hours and "dark spots" are observed after a short time already.

## Claims

1. An electroluminescent device comprising:
an electroluminescent element which includes
an electroluminescent organic layer disposed between a hole-injecting electrode and an electron-injecting electrode; and
a housing which comprises
a first shaped part, a second shaped part and
an electrical leadthrough which contacts an electrode of said electroluminescent element;
said housing enclosing said electroluminescent element,
said electroluminescent element being mounted on said first shaped part,
said first and second shaped part being connected to each other by means of a closed ring of a sealing material, and
a clearance being present between said electroluminescent element and said second shaped part,
**characterized in that**
said sealing material is a low-melting metal alloy rendering the housing air-tight and waterproof, and
said second shaped part is provided with said electrical leadthrough which is electrically insulated from said closed ring.

2. An electroluminescent device as claimed in Claim 1, **characterized in that** said electrical leadthrough is led through said second shaped part.

3. An electroluminescent device as claimed in Claim 1, **characterized in that** said electrical leadthrough is provided on said second shaped part.

4. An electroluminescent device as claimed in Claim 1, **characterized in that** the electrical leadthrough comprises a low-melting glass filled with silver particles,
the electrical leadthrough is electrically insulated from the closed ring of a low-melting metal alloy by a patterned layer of a low-melting glass, and
the closed ring of a low-melting metal alloy is supported by a patterned bonding layer of a low-melting glass filled with silver particles.

5. A method of manufacturing an electroluminescent device comprising the steps of:
mounting on a first plate,
an electroluminescent element, which comprises
an electroluminescent organic layer disposed between a hole-injecting electrode and an electron-injecting electrode,
selectively providing said first plate with a bonding layer according to a desired pattern, said pattern including a first closed ring,
selectively providing a second plate with a layer of a low-melting metal alloy according to a desired pattern, said pattern including a second closed ring, and with an electrical leadthrough which is electrically insulated from said second closed ring,
said second closed ring being mated to said first closed ring,
melting the low-melting metal alloy by heating said second closed ring to a temperature above the melting point of the low-melting metal alloy,
joining said first and said second plate to each other by mating the first and the second closed ring,
while forming an air tight and waterproof housing which encloses said electroluminescent element,
while bringing said electrical leadthrough and an electrode of said electroluminescent element into contact with each other,
while forming a clearance between said electroluminescent element and said second plate, and
solidifying said molten low-melting metal alloy.

6. A method of manufacturing an electroluminescent device as claimed in Claim 5, **characterized in that** use is made of a common first and a common second plate by means of which a plurality of integrated electroluminescent devices are simultaneously made, and which method, after solidification the molten low-melting metal alloy, comprises the step of separating the plurality of integrated electroluminescent devices into a plurality of discrete electroluminescent devices.

## Patentansprüche

1. Elektrolumineszierende Vorrichtung, welche die nachfolgenden Elemente umfasst:
- ein elektrolumineszierendes Element, das die nachfolgenden Teile aufweist:
- eine elektrolumineszierende organische Schicht, vorgesehen zwischen eine Lochinjizierenden Elektrode und einer Elektron-injizierenden Elektrode; und
- ein Gehäuse, das die nachfolgenden Teile enthält
- einen ersten Formteil, einen zweiten Formteil und
- eine elektrische Durchführung, die eine Elektrode des genannten elektrolumineszierenden Elementes kontaktiert;
wobei das genannte Gehäuse das genannte elektrolumineszierende Element einschließt,
wobei das genannte elektrolumineszierende Element auf dem genannten ersten Formteil angeordnet ist,
wobei der erste und der zweite Formteil mit Hilfe eines geschlossenen Ringes aus einem Dichtungsmaterial miteinander verbunden sind, und
wobei zwischen dem genannten elektrolumineszierenden Element und dem genannten zweiten Formteil ein Raum vorgesehen ist,
**dadurch gekennzeichnet, dass**
das genannte Dichtungsmaterial eine Metalllegierung mit einem niedrigen Schmelzpunkt ist, wodurch das Gehäuse luftdicht und wasserdicht gemacht wird, und
wobei der genannte zweite Formteil mit der genannten elektrischen Durchführung versehen wird, die gegenüber dem geschlossenen Ring elektrisch isoliert ist.

2. Elektrolumineszierende Vorrichtung nach Anspruch 1, **dadurch gekennzeichnet, dass** die genannte elektrische Durchführung durch den genannten zweiten Formteil hindurch geführt wird.

3. Elektrolumineszierende Vorrichtung nach Anspruch 1, **dadurch gekennzeichnet, dass** die genannte elektrische Durchführung auf dem genannten zweiten Formteil vorgesehen ist.

4. Elektrolumineszierende Vorrichtung nach Anspruch 1, **dadurch gekennzeichnet, dass** die elektrische Durchführung ein Glas mit einem niedrigen Schmelzpunkt, gefüllt mit Silberteilchen aufweist,
die elektrische Durchführung gegenüber dem geschlossenen Ring aus einer Metalllegierung mit einem niedrigen Schmelzpunkt durch eine mit einem Muster versehene Schicht aus einem Glas mit einem niedrigen Schmelzpunkt elektrisch isoliert ist, und
der geschlossene Ring aus einer Metalllegierung mit einem niedrigen Schmelzpunkt durch eine mit einem Muster versehene begrenzende Schicht aus einem Glas mit einem niedrigen Schmelzpunkt, gefüllt mit Silberteilchen, getragen wird.

5. Verfahren zum Herstellen einer elektrolumineszierenden Vorrichtung, wobei dieses Verfahren die nachfolgenden Verfahrensschritte umfasst:
- das auf einer ersten Platte Montieren
eines elektrolumineszierenden Elementes, das die nachfolgenden Teile aufweist:
eine elektrolumineszierende organische Schicht, vorgesehen zwischen einer Lochinjizierenden Elektrode und einer Elektron-injizierenden Elektrode,
- das selektive Versehen der genannten ersten Platte mit einer Begrenzungsschicht entsprechend einem gewünschten Muster, wobei das genannte Muster einen ersten geschlossenen Ring aufweist,
- das selektive Versehen einer zweiten Platte mit einer Schicht aus einem Metalllegierung mit einem niedrigen Schmelzpunkt entsprechend einem gewünschten Muster, wobei das genannte Muster einen zweiten geschlossenen aufweist, und mit einer elektrischen Durchführung, die gegenüber dem genannten zweiten geschlossenen Ring elektrisch isoliert ist,
wobei der genannte zweite geschlossene Ring an den genannten ersten geschlossenen Ring angepasst ist,
das Schmelzen der Metalllegierung mit dem niedrigen Schmelzpunkt durch Erhitzung des genannten geschlossenen Ringes auf eine Temperatur über dem Schmelzpunkt der Metalllegierung mit dem niedrigen Schmelzpunkt,
das Zusammenfügen der genannten ersten und der genannten zweiten Platte aneinander, indem der erste und der zweite geschlossene Ring gepaart werden,
wobei ein luftdichtes und wasserdichtes Gehäuse gebildet wird, das das genannte elektrolumineszierende Element umfasst,
wobei die genannte elektrische Durchführung und eine Elektrode des genannten elektrolumineszierenden Elementes miteinander in Kontakt gebracht werden,
wobei zwischen dem genannten elektrolumineszierenden Element und der genannten zweiten Platte ein Raum geschaffen wird
und
das Erhärten der genannten geschmolzenen Metalllegierung mit dem niedrigen Schmelzpunkt.

6. Verfahren zum Herstellen einer elektrolumineszierenden Vorrichtung nach Anspruch 5, **dadurch gekennzeichnet, dass** eine gemeinsame erste und eine gemeinsame zweite Platte verwendet werden, mit deren Hilfe eine Anzahl integrierter elektrolumineszierender Vorrichtungen gleichzeitig hergestellt werden, und wobei dieses Verfahren, nach Erhärtung der Metalllegierung mit dem niedrigen Schmelzpunkt den Verfahrensschritt der Trennung der Anzahl integrierter elektrolumineszierender Vorrichtungen in eine Anzahl diskreter elektrolumineszierender Vorrichtungen umfasst.

## Revendications

1. Dispositif électroluminescent comprenant :
un élément électroluminescent qui comprend
une couche organique électroluminescente disposée entre une électrode d'injection de trous et une électrode d'injection d'électrons, et
un boîtier qui comprend
une première partie conformée, une deuxième partie conformée, et
une traversée électrique qui entre en contact avec une électrode dudit élément électroluminescent ;
ledit boîtier renfermant ledit élément électroluminescent ;
ledit élément électroluminescent étant monté sur ladite première partie conformée ;
lesdites première et deuxième parties conformées étant connectées l'une à l'autre au moyen d'un anneau fermé de matériau de scellement, et
un espace libre étant présent entre ledit élément électroluminescent et ladite deuxième partie conformée ;
**caractérisé en ce que**
ledit matériau de scellement est un alliage métallique à bas point de fusion rendant le boîtier imperméable à l'air et à l'eau, et
ladite deuxième partie conformée est pourvue de ladite traversée électrique qui est électriquement isolée dudit anneau fermé.

2. Dispositif électroluminescent suivant la revendication 1, **caractérisé en ce que** ladite traversée électrique traverse ladite deuxième partie conformée.

3. Dispositif électroluminescent suivant la revendication 1, **caractérisé en ce que** ladite traversée électrique est déposée sur ladite deuxième partie conformée.

4. Dispositif électroluminescent suivant la revendication 1, **caractérisé en ce que** la traversée électrique comprend un verre à bas point de fusion chargé de particules d'argent ;
la traversée électrique est électriquement isolée de l'anneau fermé d'un alliage métallique à bas point de fusion par une couche modelée d'un verre à bas point de fusion, et
l'anneau fermé d'un alliage métallique à bas point de fusion est supporté par une couche de liaison modelée d'un verre à bas point de fusion chargé de particules d'argent.

5. Procédé de fabrication d'un dispositif électroluminescent comprenant les étapes suivantes :
monter, sur une première plaque,
un élément électroluminescent, qui comprend
une couche organique électroluminescente disposée entre une électrode d'injection de trous et une électrode d'injection d'électrons ;
munir sélectivement ladite première plaque d'une couche de liaison suivant un modèle souhaité, ledit modèle comprenant un premier anneau fermé ;
munir sélectivement une deuxième plaque d'une couche d'un alliage métallique à bas point de fusion suivant un modèle souhaité, ledit modèle comprenant un deuxième anneau fermé, et d'une traversée électrique qui est électriquement isolée dudit deuxième anneau fermé, ledit deuxième anneau fermé correspondant audit premier anneau fermé ;
fondre l'alliage métallique à bas point de fusion en chauffant ledit deuxième anneau fermé à une température supérieure au point de fusion de l'alliage métallique à bas point de fusion ;
réunir ladite première et ladite deuxième plaques l'une à l'autre en faisant correspondre le premier et le deuxième anneaux fermés ;
tout en formant un boîtier imperméable à l'air et à l'eau qui renferme ledit élément électroluminescent ;
tout en amenant ladite traversée électrique et une électrode dudit élément électroluminescent en contact l'un avec l'autre ;
tout en formant un espace libre entre ledit élément électroluminescent et ladite deuxième plaque, et
solidifier ledit alliage métallique à bas point de fusion fondu.

6. Procédé de fabrication d'un dispositif électroluminescent suivant la revendication 5, **caractérisé en ce qu'**il est fait usage d'une première plaque commune et d'une deuxième plaque commune au moyen desquelles une pluralité de dispositifs électroluminescents intégrés sont simultanément fabriqués et lequel procédé, après solidification de l'alliage métallique à bas point de fusion fondu, comprend l'étape visant à séparer la pluralité de dispositifs électroluminescents intégrés en une pluralité de dispositifs électroluminescents discrets.
